# EUROPEAN PATENT APPLICATION

(11) **EP 2 770 531 A2**
(43) Date of publication of application: **27.08.2014**
(21) Application number: 14156313.0
(22) Date of filing: 24.02.2014
(51) Int. Cl.: H01L 23/495

(54) **Electronic component connection structure**

(30) Priority: 26.02.2013 JP 2013036232; 13.09.2013 JP 2013190756
(71) Applicant: KABUSHIKI KAISHA TOKAI RIKA DENKI SEISAKUSHO, Niwa-gun, Aichi 480-0195 (JP)
(72) Inventor: Ito, Hajime, Niwa-gun, Aichi 480-0195 (JP)
(74) Representative: TBK

(57) **Abstract**

A connection structure for an electronic component, which is set on two lead frames (2, 3) spaced apart from each other. The electronic component (4) is connected to the two lead frames (2, 3) by a conductive joining member (5). The connection structure includes two electrodes (41 b) arranged on at least portions of a lower surface of the electronic component (4). The two electrodes (41 b) respectively face the two lead frames (2, 3). A receiving surface (21) is included in each of the two lead frames (2, 3) immediately below the corresponding electrode (41 b). The receiving surface (21) extends from a supporting portion supporting the electronic component (4) toward the other one of the lead frames (2, 3) and away from the electronic component. The conductive joining member (5) is located between the receiving surface (21) of each of the two lead frames (2, 3) and the corresponding one of the electrodes (41 b).

## Description

The present invention relates to a structure that connects an electronic component to two lead frames, which are spaced apart from each other, with a conductive joining member so that the electronic component bridges the lead frames.

Japanese Laid-Open Patent Publication No. 2007-234737 discloses a technique used in a chip capacitor connection structure that forms a thin stress reduction portion in each lead frame. The thin stress reduction portion reduces the stress generated in a conductive joining member.

The stress generated in the conductive joining member is concentrated between the chip capacitor and the lead frame. The thickness of the conductive joining member located between the chip capacitor and the lead frame greatly affects the connection reliability. When the conductor joining member is thin, the connection reliability decreases even when using the thin stress reduction portion.

One aspect of the present invention is a connection structure for an electronic component. The electronic component bridges two lead frames that are spaced apart from each other, and the electronic component is connected to the two lead frames by a conductive joining member. The connection structure includes two electrodes arranged on at least portions of a lower surface of the electronic component. The two electrodes respectively face the two lead frames. A receiving surface is included in each of the two lead frames immediately below the corresponding electrode. The receiving surface extends from a supporting portion, which supports the electronic component, toward the other one of the lead frames and away from the electronic component. The conductive joining member is located between the receiving surface of each of the two lead frames and the corresponding one of the electrodes.

A further aspect of the present invention is a method for connecting an electronic component to two lead frames, which are spaced apart from each other on a substrate, with a conductive joining member. The electronic component bridges the lead frames and includes two electrodes arranged on at least portions of a lower surface of the electronic component, and each of the two lead frames includes a receiving surface that extends away from the electronic component when the electronic component is set on the lead frames. The method includes arranging the two lead frames spaced apart from each other on the substrate so that the receiving surfaces and the substrate are located on opposite sides of the lead frames, arranging the conductive joining member on each of the two lead frames, bridging the electronic component over the two lead frames when the two electrodes of the electronic component are each in contact with the conductive joining member, and melting the conductive joining member so that the conductive joining member is located between each of the two electrodes of the electronic component and the receiving surface of the corresponding one of the lead frames.

Other aspects and advantages of the present invention will become apparent from the following description, taken in conjunction with the accompanying drawings, illustrating by way of example the principles of the invention.

The invention, together with objects and advantages thereof, may best be understood by reference to the following description of the presently preferred embodiments together with the accompanying drawings in which:
Fig. 1 is a cross-sectional view showing one example of an electronic component connection structure;
Fig. 2 is an enlarged cross-sectional view of the electronic component connection structure;
Fig. 3 is a bottom view of a chip capacitor;
Fig. 4 is a cross-sectional view illustrating a lead frame arrangement step in an electronic component connection process;
Fig. 5 is a cross-sectional view illustrating a tentative connection step subsequent to a connection preparation step;
Fig. 6 is a cross-sectional view illustrating a comparative example of an electronic component connection structure;
Fig. 7 is a cross-sectional view illustrating another example of an electronic component connection structure;
Fig. 8 is a side view showing a first mode of the electronic component connection structure;
Fig. 9 is a plan view of a lead frame;
Fig. 10 is a side view showing a second mode of the electronic component connection structure;
Fig. 11 is a plan view of the lead frame;
Fig. 12 is a side view showing a third mode of the electronic component connection structure; and
Fig. 13 is a plan view of the lead frame.

One embodiment of an electronic component connection structure will now be described.

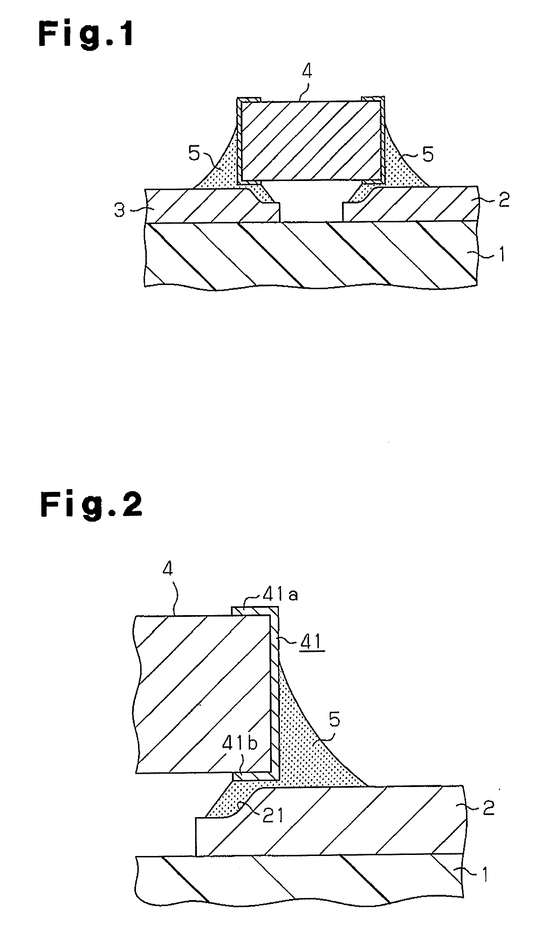

As shown in Fig. 1, a substrate 1 includes an upper surface on which two plate-shaped lead frames 2 and 3 are arranged spaced apart from each other. Insert molding, for example, is performed to integrally form the lead frames 2 and 3 with the substrate 1. A chip capacitor 4, which is one example of an electronic component, bridges the two lead frames 2 and 3. Solder 5, which serves as a conductive joining member, connects the chip capacitor 4 to the two lead frames 2 and 3.

Referring to Fig. 2, an electrode 41 is arranged on each of the two ends of the chip capacitor 4 extending from the upper surface via the side surface to the lower surface. Fig. 2 shows only the right electrode 41. Each electrode 41 includes two opposite ends defining a first electrode portion 41 a, which is in contact with the upper surface of the chip capacitor 4, and a second electrode portion 41 b, which is in contact with a lower surface of the chip capacitor 4. The first electrode portion 41 a is formed by inwardly bending the first end of the electrode 41, and the second electrode portion 41 b is formed by bending the second end of the electrode 41. A portion of the lead frame 2 located immediately below the electrode portion 41 b defines a receiving surface 21. The receiving surface 21 extends from a supporting portion where the lead frame 2 would contact and support the chip capacitor 4 if there were no solder 5. Further, the receiving surface 21 extends toward the other lead frame 3 and away from the chip capacitor 4. The lead frame 2 includes opposite surfaces, one facing the substrate 1 and the other facing the chip capacitor 4. The surface facing the substrate 1 is entirely flat, and the surface facing the chip capacitor 4 includes a recess defining the receiving surface 21. The lead frame 3 also includes a similar recess. The two lead frames 2 and 3 are spaced apart from each other on the substrate 1 so that the two recesses are directed toward each other. Each recess is formed in, for example, a pressing process.

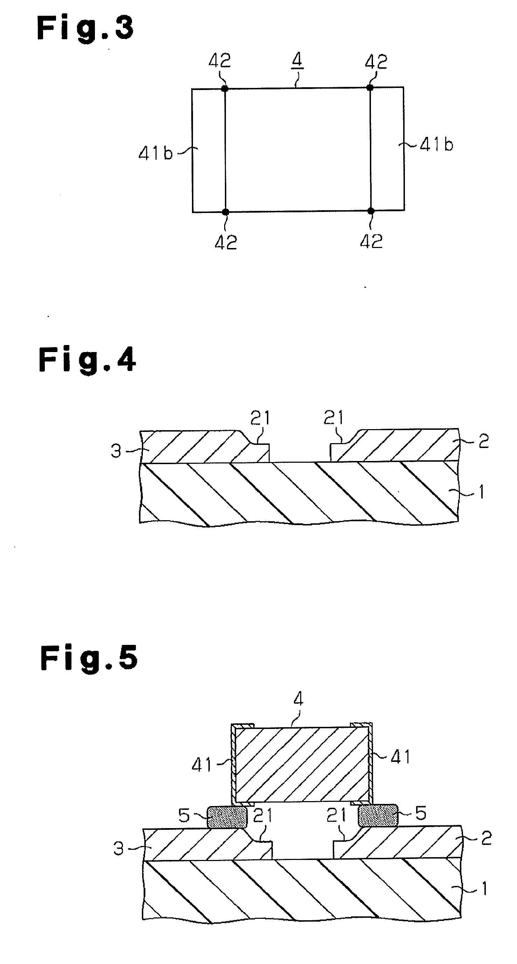

Referring to Fig. 3, each of the two electrode portions 41 b on the lower surface of the chip capacitor 4 has an innermost edge that includes two corners 42. Two ends of the innermost edge respectively correspond to the two corners 42 of the electrode 41 b. Two ends of outermost edge of each of the two electrode portions 41 b respectively correspond to two corners of the chip capacitor 4. Thus, the two electrode portions 41 b include a total of four corners 42. The receiving surface 21 of the lead frames 2 and 3 are formed in correspondence with the four corners 42. The receiving surface 21 of the lead frame 2 extends from the supporting portion, which supports the chip capacitor 4, via a portion located immediately below the two corners 42 of the electrode portion 41 b, and toward the other lead frame 3, which is paired with the lead frame 2. In the same manner, the receiving surface 21 of the lead frame 3 extends from the supporting portion, which supports the chip capacitor 4, via a portion located immediately below the two corners 42 of the electrode portion 41 b, and toward the lead frame 2. The solder 5 is located between each receiving surface 21 and the electrode portions 41 b. This electrically and mechanically connects the electrode portions 41 b to the lead frames 2 and 3 with a sufficient amount of the solder 5.

An electronic component connection process that obtains the connection structure will now be described.

Referring to Fig. 4, in a lead frame arrangement step, insert molding is performed to integrate the lead frames 2 and 3 with the substrate 1 so that the receiving surfaces 21 and the substrate 1 are located on opposite sides of the lead frames 2 and 3.

Referring to Fig. 5, in a connection preparation step, pellets of the solder 5 are tentatively fixed onto the lead frames 2 and 3. In a tentative connection step, the chip capacitor 4 bridges the two lead frames 2 and 3 with the electrodes 41 contacting the solder 5.

In a main connection process, the pellets of the solder 5 are melted so that the melted solder 5 is partially located between the electrodes 41 of the chip capacitor 4 and the receiving surfaces 21 of the lead frames 2 and 3. This obtains the connection structure for the chip capacitor 4 shown in Fig. 1.

The operation of the electronic component connection structure will now be described.

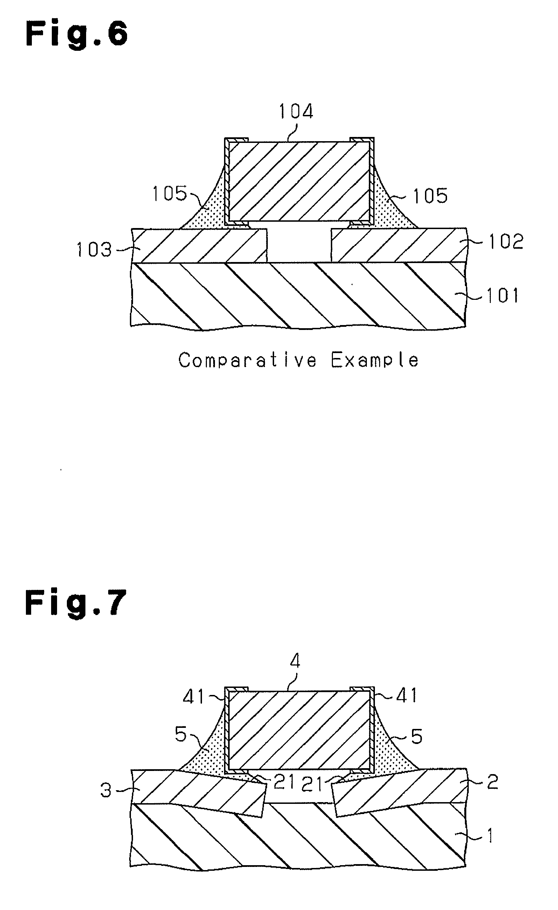

Fig. 6 shows a comparative example. In this example, two lead frames 102 and 103 are spaced apart on a substrate 101. Each of the lead frames 102 and 103 does not include the receiving surface 21. A chip capacitor 104 bridges the two lead frames 102 and 103. Solder 105 connects the chip capacitor 104 to the two lead frames 102 and 103. The stress generated in the solder 105 is concentrated between the chip capacitor 104 and the lead frames 102 and 103. The solder 105 is thin between the chip capacitor 104 and the lead frames 102 and 103.

In contrast, in the present example, the receiving surface 21 is formed in each of the lead frames 2 and 3, and the solder 5 is located and received between the receiving surfaces 21 and the electrodes 41 of the chip capacitor 4. The stress generated in the solder 5 is concentrated between the chip capacitor 4 and the lead frames 2 and 3. However, the solder 5, which is located between the chip capacitor 4 and the lead frames 2 and 3, is thicker than the comparative example. This disperses and reduces the stress. Further, the increased amount of the solder 5 increases the strength.

The present embodiment has the advantages described below.
(1) The solder 5 is located and received between each electrode 41 b of the chip capacitor 4 and the receiving surface 21 of the corresponding one of the lead frames 2 and 3. This disperses and reduces the stress concentrated between the chip capacitor 4 and the lead frames 2 and 3. Accordingly, the connection reliability may be improved.
(2) The solder 5 is located immediately below the two corners 42 of each electrode portion 41 b where the stress is largest. The thickness of the solder 5 is increased at this location thereby limiting cracking.
(3) The receiving surface 21 of each of the lead frames 2 and 3 extends from the supporting portion, which supports the chip capacitor 4, via a portion located immediately below the two corners 42 of the electrode portion 41 b, and toward the other one of the lead frames 2 and 3. The distance between the two supporting portions is less than the length of the chip capacitor 4. In this manner, the narrowed distance between the two lead frames 2 and 3 facilitates the mounting of the chip capacitor 4.
(4) The two lead frames 2 and 3 are first arranged on the substrate 1 spaced apart from each other. Then, the pellets of the two solders 5 are arranged on the lead frames 2 and 3 so that the lead frames 2 and 3 are located at the lower side of the solders 5. Subsequently, the chip capacitor 4 is arranged on an upper side of the solders 5. Thus, the melted solder 5 is easily received in the receiving surfaces 21. Accordingly, advantages (1) and (2) are easily achieved.
(5) The receiving surfaces 21 of the two lead frames 2 and 3 are symmetrically formed in correspondence with the four corners 42 of the chip capacitor 4. This equally reduces stress.

It should be apparent to those skilled in the art that the present invention may be embodied in many other specific forms without departing from the spirit or scope of the invention. Particularly, it should be understood that the present invention may be embodied in the following forms.

Referring to Fig. 7, the two receiving surfaces 21 may be formed by bending the opposing ends of the two lead frames 2 and 3 toward the substrate 1 and away from the chip capacitor 4. The solder 5 is located between the receiving surface 21 and the electrode 41. Further, the receiving surface 21 is linearly inclined. This facilitates the positioning of the chip capacitor 4.

The receiving surface 21 of each of the lead frames 2 and 3 may extend from the supporting portion, which supports the chip capacitor 4, to immediately below the two corners 42. Alternatively, under the condition that the solder 5 between the receiving surface 21 and the electrode 41 has sufficient thickness, the receiving surface 21 of the lead frames 2 and 3 may extend from the supporting portion to just before the two corners 42.

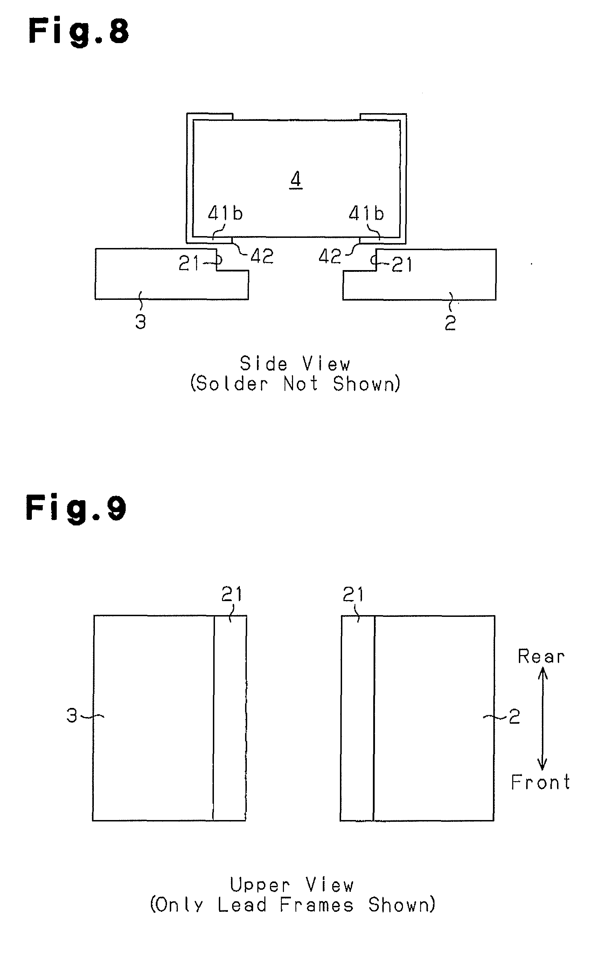

Referring to Figs. 8 and 9, the receiving surfaces 21 may extend continuously from the front toward the rear of the lead frames 2 and 3. The direction extending from the front toward the rear of each of the frames 2 and 3 is orthogonal to the direction in which the chip capacitor 4 bridges the lead frames 2 and 3. The inner region in the upper surface of each of the lead frames 2 and 3 excluding the receiving surface 21 defines a mounting region for the chip capacitor 4.

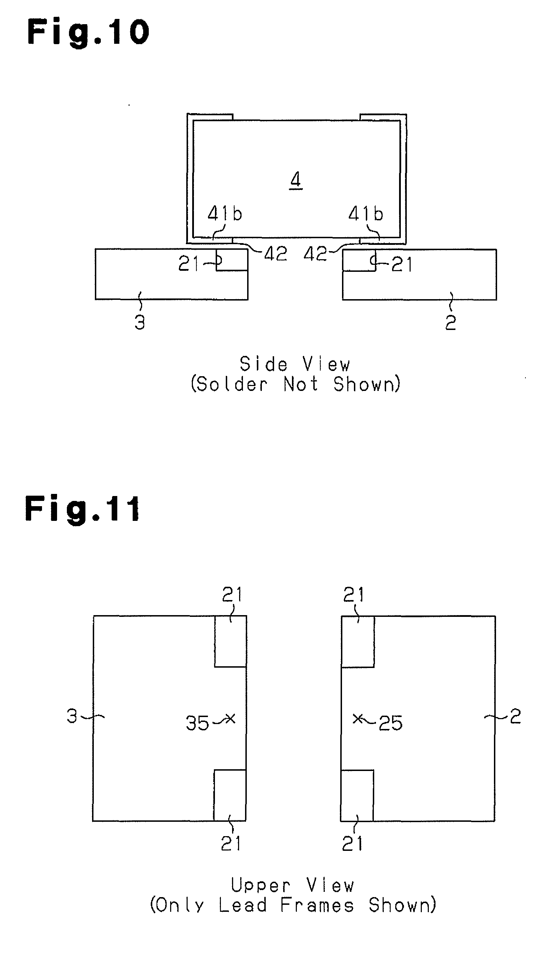

Referring to Figs. 10 and 11, four receiving surfaces 21 may be formed in four regions corresponding to the four corners 42 of the two lead frames 2 and 3. In contrast with the structure of Figs. 8 and 9, an inner region 25 is formed between the two receiving surfaces 21 of the lead frame 2, and an inner region 35 is formed between the two receiving surfaces 21 of the lead frame 3. This enlarges the mounting region of the chip capacitor 4 and improves the mounting stability of the chip capacitor 4.

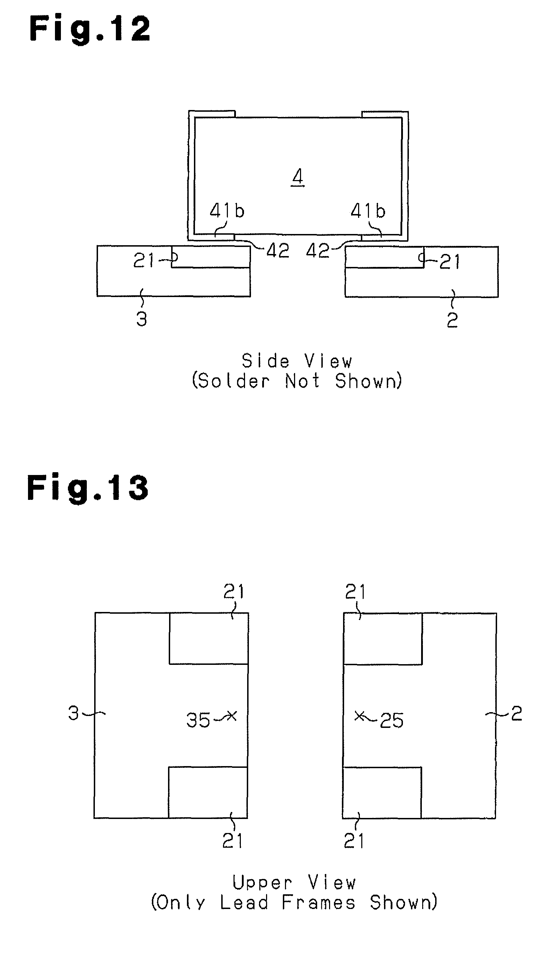

Referring to Figs. 12 and 13, four receiving surfaces 21 may be formed in four regions corresponding to the four corners 42 of the two lead frames 2 and 3, and the four receiving surfaces 21 may cooperate to allow the solder 5 to be located between the four corners in the lower surface of the chip capacitor 4 and the four receiving surfaces 21. In contrast with the structure of Figs. 8 and 9, an inner region 25 is formed between the two receiving surfaces 21 of the lead frame 2 and an inner region 35 is formed between the two receiving surfaces 21 of the lead frame 3. This enlarges the mounting region of the chip capacitor 4 and improves the mounting stability of the chip capacitor 4. Further, in contrast with the structure of Figs. 10 and 11, the solder 5 is also located immediately below the four corners in the lower surface of the chip capacitor 4. This increases the thickness of the solder 5 at these locations thereby limiting cracking.

The electronic component is not limited to a chip capacitor 4.

The conductive joining member is not limited to the solder 5.

The present examples and embodiments are to be considered as illustrative and not restrictive, and the invention is not to be limited to the details given herein, but may be modified within the scope and equivalence of the appended claims.

A connection structure for an electronic component, which is set on two lead frames (2, 3) spaced apart from each other. The electronic component (4) is connected to the two lead frames (2, 3) by a conductive joining member (5). The connection structure includes two electrodes (41 b) arranged on at least portions of a lower surface of the electronic component (4). The two electrodes (41 b) respectively face the two lead frames (2, 3). A receiving surface (21) is included in each of the two lead frames (2, 3) immediately below the corresponding electrode (41 b). The receiving surface (21) extends from a supporting portion supporting the electronic component (4) toward the other one of the lead frames (2, 3) and away from the electronic component. The conductive joining member (5) is located between the receiving surface (21) of each of the two lead frames (2, 3) and the corresponding one of the electrodes (41 b).

## Claims

1. A connection structure for an electronic component, wherein the electronic component bridges two lead frames that are spaced apart from each other, and the electronic component is connected to the two lead frames by a conductive joining member, the connection structure **characterized by** comprising:
two electrodes (41 b) arranged on at least portions of a lower surface of the electronic component, wherein the two electrodes (41 b) respectively face the two lead frames; and
a receiving surface (21) included in each of the two lead frames immediately below the corresponding electrode (41 b), wherein the receiving surface (21) extends from a supporting portion, which supports the electronic component, toward the other one of the lead frames and away from the electronic component,
wherein the conductive joining member is located between the receiving surface (21) of each of the two lead frames and the corresponding one of the electrodes (41 b).

2. The connection structure according to claim 1, **characterized in that**
each of the two electrodes (41 b) includes two corners, and
the receiving surface (21) of each of the two lead frames includes a portion located immediately below the two corners of the corresponding one of the electrodes (41 b).

3. The connection structure according to claim 1 or 2, **characterized in that** the receiving surface (21) of each of the two lead frames extends from the supporting portion via a location immediately below the two corners of the electrode (41 b) and toward the other one of the lead frames.

4. The connection structure according to any one of claims 1-3, **characterized in that**:
the receiving surface (21) of each of the two lead frames is one of two receiving surfaces (21), and
the receiving surfaces (21) are respectively located in correspondence with the two corners of the corresponding electrode (41 b).

5. The connection structure according to any one of claims 1-4, **characterized in that**:
each of the two electrodes (41 b) is inwardly bent from a side surface of the electronic component to extend along a lower surface of the electronic component,
each of the two electrodes (41 b) includes an innermost edge and an outermost edge located on the lower surface of the electronic component,
two ends of the innermost edge of each of the two electrodes (41 b) respectively correspond to two corners of the electrode (41 b),
two ends of the outermost edge of each of the two electrodes (41 b) respectively correspond to two corners of the electronic component,
the receiving surface (21) of each of the two lead frames is arranged in correspondence with the two corners of the corresponding electrode (41 b), and
two receiving surfaces (21) of the two lead frames cooperate to allow the conductive joining member to be located between each of the two receiving surfaces (21) and the corresponding two corners of the corresponding electrode (41 b).

6. The connection structure according to any one of claims 1-4, **characterized in that**:
each of the two electrodes (41 b) is inwardly bent from a side surface of the electronic component to extend along a lower surface of the electronic component,
each of the two electrodes (41 b) includes an innermost edge located on the lower surface of the electronic component,
the innermost edge of each of the two electrodes (41 b) has two corners of the electrode (41 b), and
the receiving surface (21) of each of the two lead frames is arranged in correspondence with the two corners of the corresponding electrode (41 b).

7. The connection structure according to any one of claims 1-6, **characterized in that** the two receiving surfaces (21) of the two lead frames are symmetric to each other.

8. A method for connecting an electronic component to two lead frames, which are spaced apart from each other on a substrate, with a conductive joining member, wherein the electronic component bridges the lead frames and includes two electrodes (41 b) arranged on at least portions of a lower surface of the electronic component, and each of the two lead frames includes a receiving surface (21) that extends away from the electronic component when the electronic component is set on the lead frames, the method **characterized by** comprising:
arranging the two lead frames spaced apart from each other on the substrate so that the receiving surfaces (21) and the substrate are located on opposite sides of the lead frames;
arranging the conductive joining member on each of the two lead frames;
bridging the electronic component over the two lead frames when the two electrodes (41 b) of the electronic component are each in contact with the conductive joining member; and
melting the conductive joining member so that the conductive joining member is located between each of the two electrodes (41 b) of the electronic component and the receiving surface (21) of the corresponding one of the lead frames.
